# EUROPÄISCHE PATENTSCHRIFT

(11) **EP 0 519 167 B1**
(45) Veröffentlichungstag und Bekanntmachung des Hinweises auf die Patenterteilung: **03.01.1996**
(21) Anmeldenummer: 92105405.2
(22) Anmeldetag: 28.03.1992
(51) Int. Cl.: G01B 11/14, G01D 5/26, G01B 11/16

(54) **Mikromanipulator**
Micromanipulator
Micromanipulateur

(30) Priorität: 31.05.1991 DE 4117892
(43) Veröffentlichungstag der Anmeldung: 23.12.1992
(73) Patentinhaber: Forschungszentrum Karlsruhe GmbH, D-76133 Karlsruhe (DE)
(72) Erfinder: Bley, Peter, Dr., W-7514 Eggenstein-Leopoldshafen (DE); Mohr, Jürgen, Dr., W-7519 Sulzfeld (DE)
(74) Vertreter: Gottlob, Peter, Dipl. Ing.

(56) Entgegenhaltungen:
- DE-A- 3 720 248
- DE-A- 3 809 597
- DE-A- 3 841 557

## Beschreibung

Die Erfindung betrifft einen Mikromanipulator gemäß dem Oberbegriff von Anspruch 1.

Ein solcher Mikromanipulator ist aus der DE 38 41 557 A1 bekannt. Dieser Mikromanipulator besteht aus einem Substrat, Heizelementen und einem Manipulatorarm. Der Manipulatorarm ist in der Art eines Bimetallstreifens ausgebildet und besteht aus einer Platte aus einem ersten Material, die wenigstens teilweise durch eine Schicht aus einem zweiten Material überdeckt ist. Der Manipulatorarm ist nur teilweise mit dem Substrat fest verbunden. Der freie, nicht verbundene Teil ist in geringem Abstand parallel zur Substratebene angeordnet. Die Schicht des zweiten Materials weist einen höheren Ausdehnungskoeffizienten auf als das erste Material, aus dem die Platte gefertigt ist.

Sowohl die Platte als auch die Schicht des Manipulatorarms können als elektrische Heizwiderstände ausgebildet sein. Bei diesem Mikromanipulator bewegt sich das freie Ende des Manipulators in der Ebene des Substrats; hierbei wölbt sich der Manipulatorarm jedoch auf. Bei dieser Aufwölbung besteht die Gefahr, daß sich die Schicht von der Platte des Manipulatorarms löst.

Die DE 37 20 248 A1 beschreibt ein Verfahren zur Messung von Verformungen an Proben oder Prüfkörpern in Prüfmaschinen, mit einer Lichtquelle und einer Signalverarbeitungseinrichtung und eine Anordnung zur Durchführung des Verfahrens. Das Meßprinzip beruht darauf, das Licht einer punktförmigen Lichtquelle an einem oder zwei senkrecht auf einer Probe angebrachten Spiegeln zu reflektieren und in einen Positionsdetektor einzustrahlen. Bei einer Verformung der Probe verschiebt sich der Bildpunkt der punktförmigen Lichtquelle im Positionsdetektor. Aus der Verschiebung des Bildpunkts wird auf die Verformung der Probe geschlossen. In einem Mikromanipulator lassen sich Spiegel in dieser Art jedoch nicht anordnen; das Meßprinzip ist hierfür nicht einsetzbar.

Ein weiterer Mikromanipulator ist z. B. aus der DE 38 14 616 A1 bekannt.

Bei diesem Mikromanipulator wird unter dem Einfluß von Temperaturänderungen ein Mikrostrukturkörper gegenüber einem Substrat bewegt, der aus Metall und einem weiteren Material mit unterschiedlichen Wärmeausdehnungskoeffizienten besteht. In der bevorzugten Ausführungsform bildet das Metall einen elektrischen Heizwiderstand. Es wird jedoch auch vorgeschlagen, die Temperaturänderung durch andere Methoden wie z. B. thermische Strahlung vorzunehmen.

Der bewegliche Mikrostrukturkörper besteht aus einer rechteckigen Zunge, die aus übereinander angeordneten Schichten der verschiedenen Materialien aufgebaut ist, und zwar in der Weise, daß die Schichten in Ruhestellung parallel zum Substrat verlaufen.

Zur Überwachung der Position des Mikrostrukturkörpers oder zur Positionsregelung können auf dem Mikrostrukturkörper Sensoren angebracht sein. Die Sensoren sind als Piezowiderstände ausgebildet oder beruhen auf megnetischen, piezoelektrischen, ferroelektrischen oder kapazitiven Effekten.

Wegen der Anordnung der verschiedenen Materialien in Schichten, die parallel zum Substrat verlaufen, kann der bekannte Mikromanipulator jedoch nur Bewegungen senkrecht zum Substrat ausführen. Zwar wird auch angegeben, daß eine Kippbewegung um einen kleinen Winkel möglich sei, doch ist diese Bewegung begrenzt. Keinesfalls können Bewegungen in einer zum Substrat parallelen Ebene durchgeführt werden.

Aus der DE 38 14 617 A1 ist bekannt, den Mikromanipulator nach der Druckschrift DE 38 14 616 A1 als Greifer auszubilden.

In der DE 38 09 597 A1 wird ein mikromechanisches Stellelement beschrieben, dessen Funktionsweise dem Mikromanipulator der Druckschrift DE 38 14 616 A1 entspricht.

Auch in den beiden letztgenannten Druckschriften erfolgt die Bewegung des Mikrostrukturkörpers senkrecht zum Substrat.

Es kann jedoch vorteilhaft sein, wenn sich der Mikrostrukturkörper nicht senkrecht zum Substrat, sondern in einer dazu parallelen Ebene bewegt. Damit lassen sich zum Beispiel Zahnstangen und Zahnräder, die auf demselben Substrat angeordnet sind, bewegen.

Aus der DE 37 27 142 A1 sind Mikrosensoren bekannt, die die Gestalt eines Biegebalkens mit kammförmigen Enden annehmen. wobei der Biegebalken nur in seinem mittleren Bereich mit dem Substrat fest verbunden ist, während die übrigen Bereiche das Substrat nicht berühren und daher in der Substratebene frei auslenkbar sind.

Diese Sensoren werden als Beschleunigungssensoren eingesetzt und enthalten demzufolge keine verschiedenen Materialien mit unterschiedlichem Wärmeausdehnungskoeffizienten. Die Bewegung der Mikrostrukturkörper wird über elektrische Schaltkreise angezeigt.

Aufgabe der Erfindung ist es, ausgehend vom genannten Stand der Technik, Mikromanipulatoren vorzuschlagen, die eine Bewegung in der Substratebene zulassen, wobei die Bewegung des Mikrostrukturkörpers mit anderen Methoden detektiert wird.

Die mechanische Stabilität des Mikrostrukturkörpers soll verbessert werden.

Die Aufgabe wird erfindungsgemäß durch die im ersten Patentanspruch gekennzeichneten Merkmale gelöst. Der weitere Patentanspruch gibt eine vorteilhafte Ausführungsform an.

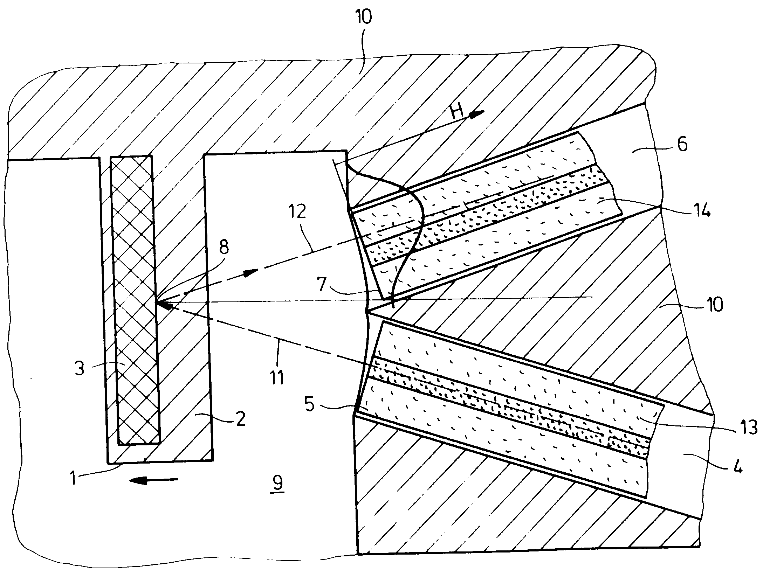

In der Figur ist der erfindungsgemäße Manipulator gemäß dem ersten Patentanspruch dargestellt.

Beim erfindungsgemäßen Mikromanipulator haftet der bewegliche Mikrostrukturkörper 1 nicht direkt an dem Substrat 9, sondern das Substrat wird mit einer Schicht bedeckt, die strukturiert ist und die nur zum Teil 10 mit dem Substrat verbunden ist. Der nicht mit dem Substrat verbundene Teil 1 der Schicht bildet den beweglichen Mikrostrukturkörper. Dieser weist im wesentlichen die Form eines schmalen Rechtecks auf, das lediglich mit einer der Schmalseiten mit dem fest am Substrat haftenden Teil 10 der strukturierten Schicht verbunden ist. Die übrigen Seiten sind mit keinem weiteren Teil verbunden.

Die Strukturen der strukturierten Schicht sind so gewählt, daß sich der Mikrostrukturkörper in der Ebene des Substrats bewegen kann. Der Mikrostrukturkörper 1 weist einen solchen Abstand zum Substrat 9 auf, daß seine Bewegung durch das Substrat nicht gehemmt wird. Die Bewegung des Mikrostruktur-körpers 1 wird durch eine - in senkrechter Richtung auf das Substrat gesehen - asymmetrische Verteilung des Metallanteils erreicht. Das Metall bildet die Form eines Bandes 3, das in dem aus Kunststoff bestehenden Teil 2 des Mikrostrukturkörpers 1 vollständig versenkt ist, wobei seine Dicke der Dicke des Kunststoffanteils entspricht.

Das Metall 3 und der Kunststoff 2 werden so gewählt, daß sie einen unterschiedlichen Wärmeausdehnungskoeffizienten besitzen. Unter asymmetrischer Verteilung des Metallanteils soll verstanden werden, daß das Metallband parallel zu den Längsseiten des Rechtecks, das der Mikrostrukturkörper bildet, angeordnet wird, jedoch seitlich aus der Mitte versetzt, so daß der Mikrostrukturkörper die Funktion eines Bimetallstreifens erhält, der eine Bewegung parallel zur Substratebene ausführt.

In den Teil 10 der strukturierten Schicht, die fest mit dem Substrat verbunden ist, sind erfindungsgemäß zum Substrat 9 parallele Kanäle 4, 6 eingelassen, die zwei Lichtleiter 5, 7 aufnehmen. Mit diesen Lichtleitern kann einerseits der bewegliche Mikrostrukturkörper 1 erwärmt werden, so daß er die angegebene Bewegung ausführt. Andererseits kann mit Hilfe dieser beiden Lichtleiter die Position des beweglichen Mikrostrukturkörpers erfaßt werden, und zwar auch in dem Fall, daß die Bewegung des Mikrostrukturkörpers allein durch eine Änderung der Umgebungstemperatur erfolgt.

Einer der beiden Lichtleiter 4 dient in diesem Fall zum Einstrahlen von Licht. Die Anordnung dieses ersten Lichtleiters ist so gewählt, daß das an seiner Eingangsseite 13 eingestrahlte Licht den Mikrostrukturkörper auf einer seiner Längsseiten in einem Punkt 8 (der wegen der Lichtstreuung auch flächenhaft ausgedehnt sein kann) trifft. Dieser Punkt 8 braucht nicht notwendigerweise auf der Oberfläche des Mikrostrukturkörpers liegen. Wenn der Kunststoff aus einem durchsichtigen Material, etwa Polymethylmethacrylat, besteht, liegt der Punkt auf der Oberfläche des Metallbandes 3.

An diesem Punkt 8 wird das einfallende Licht 11 zumindest teilweise reflektiert.

Zur Erfassung des reflektierten Lichtstrahls 12 ist in dem Kanal 6 der zweite Lichtleiter 7 vorgesehen. Die Achse dieses Lichtleiters 7 fällt nicht mit dem Strahl 12 des reflektierten Lichts zusammen, sondern ist innerhalb der Substratebene um einen kleinen Winkel gedreht. Hierdurch wird erreicht, daß nicht die maximale Intensität I des reflektierten Lichts im Ruhezustand des Mikrostrukturkörpers, das heißt, bei einer definierten Temperatur am Ausgang 14 des Lichtleiters erfaßt wird, sondern eine geringere Intensität.

In der Figur ist der Intensitätsverlauf des reflektierten Lichts in Abhängigkeit vom Meßwinkel angegeben. Erfindungsgemäß kann daher nicht nur eine Bewegung des Mikrostrukturkörpers durch Messung der Intensität des reflektierten Lichts am Ausgang 14 des Lichtleiters 7 nachgewiesen werden, sondern auch, in welche Richtung sich der Mikrostrukturkörper bewegt.

Je nach gewähltem Winkel zwischen dem Strahl 12 des reflektierten Lichts und der Achse des Lichtleiters führt die Bewegung des Mikrostrukturkörpers 1 bei Temperaturerniedrigung zu einer höheren oder geringeren, bei Temperaturerhöhung dagegen umgekehrt zu einer geringeren oder höheren meßbaren Lichtintensität. Die Lichtintensität ändert sich daher bei Bewegungen des Mikrostrukturkörpers monoton.

In Anbetracht der Funktionsweise des erfindungsgemäßen Mikromanipulators ist daher verständlich, daß der Mikrostrukturkörper keine Rechteckform im strengen Sinn aufweisen muß. Wesentlich ist lediglich, daß er in der Weise eines Bimetallstreifens seine Lage unter Temperatureinflüssen verändern kann und daß eingestrahltes Licht in vorher definierbarer Weise reflektiert wird. Insbesondere seine freie Schmalseite kann praktischen Erfordernissen angepaßt sein.

Ein wesentlicher Vorzug des erfindungsgemäßen Mikromanipulators besteht darin, daß der Mikrostrukturkörper 1 mechanisch wesentlich stabiler ist als die bekannten Mikromanipulatoren, die aus übereinander liegenden Schichten verschiedener Materialien aufgebaut sind und bei denen die Gefahr besteht, daß sich diese Schichten unter dem Einfluß der Bewegung voneinander lösen, denn das Band aus Metall ist vollständig in den Kunststoff versenkt. Eine noch bessere mechanische Stabilität wird erreicht, wenn der Mikrostrukturkörper zusätzlich an den senkrecht zum Substrat stehenden freien Seitenflächen mit einem dünnen Metallmantel umgeben wird.

Die erfindungsgemäßen Mikromanipulatoren lassen sich nach den bekannten lithographischen (besonders mit der Röntgentiefenlithographie) und galvanotechnischen Methoden herstellen, wobei die strukturierte Schicht auf einer selektiv entfernbaren Substratdeckschicht (Opferschicht) aufgebracht wird, die im Bereich des beweglichen Mikrostrukturkörpers selektiv weggeätzt wird. Die Substratdeckschicht kann auch bereits vor dem Aufbringen der strukturierten Schicht vorstrukturiert werden, so daß sie nur im Bereich des beweglichen Mikrostrukturkörpers vorhanden ist und nach dem Auftragen der strukturierten Schicht selektiv weggeätzt werden kann. Hierbei besteht der fest mit dem Substrat verbundene Teil der strukturierten Schicht und der Mikrostrukturkörper aus demselben Material; beide werden im selben Arbeitsschritt hergestellt. Ebenso bestehen das Metallband und der Metallmantel des Mikrostrukturkörpers aus dem selben, im gleichen Arbeitsgang aufgebrachten Material. Die Metallanteile werden in einem nachfolgenden Galvanikschritt hergestellt. Ein geeignetes Verfahren zur Herstellung der erfindungsgemäßen Mikromanipulatoren ist in der bereits erwähnten DE 37 27 142 Al beschrieben.

Der erfindungsgemäße Mikromanipulator kann im Größenbereich von einigen Mikrometern bis zu einigen hundert Mikrometern hergestellt werden und eröffnet vielfältige Anwendungsmöglichkeiten in der Mikrotechnik. Beispielsweise kann er in auf Temperaturänderungen ansprechenden Mikroventilen, in Greifern, Thermoschaltern und -sensoren und in Schaltelementen für strömende Flüssigkeiten eingesetzt werden. Ferner können Zahnräder oder Zahnstangen angetrieben werden.

### Bezugszeichenliste:

1 beweglicher Mikrostrukturkörper
2 Kunststoffanteil des Mikrostrukturkörpers
3 Metallanteil des Mikrostrukturkörpers
4 Lichtleiterkanal
5 Lichtleiter
6 Lichtleiterkanal
7 Lichtleiter
8 Punkt auf dem Mikrostrukturkörper
9 Substrat
10 Teil der fest auf dem Substrat verbundenen strukturierten Schicht
11 einfallendes Licht
12 reflektiertes Licht
13 Eingangsseite des Lichtleiters 5
14 Ausgangsseite des Lichtleiters 7

## Patentansprüche

1. Mikromanipulator, bei dem
a) auf einem Substrat (9)
b) eine strukturierte Schicht (1,10) aufgebracht ist, wobei die strukturierte Schicht
- zum Teil (10) fest mit dem Substrat verbunden ist und
- zum Teil (1) einen beweglichen Mikrostrukturkörper bildet, der gegenüber dem Substrat (9) einen Abstand aufweist,
c) der Mikrostrukturkörper (1) im wesentlichen die Form eines schmalen Rechtecks hat und lediglich mit einer Schmalseite an dem fest mit dem Substrat (9) verbundenen Teil (10) der strukturierten Schicht hängt
gekennzeichnet durch die Merkmale
d) der Mikrostrukturkörper (1) ist aus Kunststoff (2) aufgebaut, in den ein Band (3) aus einem Metall, das einen anderen Wärmeausdehnungskoeffizienten als der Kunststoff aufweist, eingelassen ist, und zwar in der Weise, daß das Band (3) in senkrechter Richtung auf das Substrat (9) gesehen
- parallel zu den Langseiten des Mikrostrukturkörpers (1), jedoch seitlich versetzt angeordnet und
- vollständig in dem Kunststoff (2) des Mikrostrukturkörpers (1) versenkt ist, wobei seine Dicke in der angegebenen Richtung der Dicke des Kunststoffs (2) entspricht,
e) der fest mit dem Substrat (9) verbundene Teil (10) der strukturierten Schicht enthält in einem ersten, parallel zum Substrat (9) verlaufenden Kanal (4) einen ersten Lichtleiter (5), der so angeordnet ist, daß durch sein Ende (13) austretendes Licht (11) schräg auf einem Punkt (8) einer Langseite des Mikrostrukturkörpers (1) auftrifft,
f) der fest mit dem Substrat (9) verbundene Teil (10) der strukturierten Schicht enthält in einem zweiten, parallel zum Substrat (9) verlaufenden Kanal (6) einen zweiten Lichtleiter (7), der so angeordnet ist, daß seine Achse gegenüber dem Strahl (12) des durch den ersten Lichtleiter (5) einfallenden und am Punkt (8) des Mikrostrukturkörpers (1) reflektierten Lichts um einen solchen Winkel gedreht ist, daß sich die am Ausgang (14) des zweiten Lichtleiters (7) meßbare Intensität des Lichts bei Bewegung des Mikrostrukturkörpers monoton ändert.

2. Mikromanipulator nach Anspruch 1, bei dem die senkrecht zum Substrat (9) verlaufende Oberfläche des Mikrostrukturkörpers (1) mit Metall überzogen ist.

## Claims

1. Micromanipulator, wherein
a) there is applied to a substrate (9)
b) a structured layer (1, 10), the structured layer
- being securely connected to the substrate in respect of part (10) and
- forming a displaceable microstructure body in respect of part (1), which body is spaced from the substrate (9),
c) the microstructure body (1) substantially has the configuration of a narrow rectangle and is merely attached by one narrow side to the part (10) of the structured layer which is securely connected to the substrate (9),
characterised by the features
d) the microstructure body (1) is formed from plastics material (2), into which a strip (3) of metal, having a different coefficient of thermal expansion than the plastics material, is inserted in such a manner that the strip (3), when viewed in a direction perpendicular to the substrate (9),
- is disposed parallel to the longitudinal sides of the microstructure body (1), but laterally offset therefrom, and
- is completely immersed in the plastics material (2) of the microstructure body (1), its thickness corresponding to the thickness of the plastics material (2) in the given direction,
e) the part (10) of the structured layer securely connected to the substrate (9) contains a first photoconductor (5) in a first channel (4), which extends parallel to the substrate (9), said photoconductor being so disposed that light (11), emerging through its end (13), impinges inclinedly upon a point (8) of a longitudinal side of the microstructure body (1),
f) the part (10) of the structured layer securely connected to the substrate (9) contains a second photoconductor (7) in a second channel (6), which extends parallel to the substrate (9), said photoconductor being so disposed that its axis is rotated relative to the ray (12) of the light, which impinges through the first photoconductor (5) and is reflected at the point (8) of the microstructure body (1), through such an angle that the intensity of the light, which can be measured at the output (14) of the second photoconductor (7), changes in a monotonically decreasing manner during the movement of the microstructure body.

2. Micromanipulator according to claim 1, wherein the surface of the microstructure body (1) extending perpendicular to the substrate (9) is coated with metal.

## Revendications

1. Micromanipulateur, pour lequel on dépose:
a) sur un substrat (9)
b) une couche structurée (1, 10), où la couche structurée présente,
- une partie (10) liée solidairement au substrat et,
- une partie (1) qui forme un corps à microstructure mobile qui présente un écartement vis à vis du substrat (9),
c) le corps à microstructure (1) a essentiellement la forme d'un rectangle étroit et est accroché seulement par un petit côté de la partie (10) liée solidairement au substrat (9) de la couche structurée,
caractérisé en ce que :
d) le corps à microstructure (1) est en matière plastique (2) où est incorporée une bande (3) de métal, qui présente un autre coefficient de dilatation thermique que la matière plastique et ce, de sorte que la bande (3), en regardant perpendiculairement au substrat (9),
- est disposée parallèlement aux grands côtés du corps à microstructure (1), légèrement décalé sur le côté cependant et est complètement incorporée dans la matière plastique (2) du corps à microstructure (1), où son épaisseur correspond au sens indiqué de l'épaisseur de la matière plastique (2),
e) la partie (10) liée solidairement au substrat (9) de la couche structurée contient dans un premier canal (4) s'étendant parallèlement au substrat (9) un premier conducteur de lumière (5), qui est implanté de telle façon que la lumière (11) émise par son extrémité (13) tombe en biais sur un point (8) d'un grand côté du corps à microstructure (1),
f) la partie (10) liée solidairement au substrat (9) de la couche structurée contient dans un deuxième canal (6) s'étendant parallèlement au substrat (9) un deuxième conducteur de lumière (7), qui est implanté de telle façon que son axe fait un angle par rapport au rayon (12) de la lumière réfléchie provenant du premier conducteur de lumière (5) réfléchie au point (8) du corps de la microstructure (1), de sorte que l'intensité mesurable à la sortie (14) du deuxième conducteur de lumière (7) varie de façon monotone en fonction du déplacement du corps à microstructure.

2. Micromanipulateur selon la revendication 1 dans lequel la surface du corps à microstructure (1) s'étendant perpendiculairement au substrat (9) est revêtue de métal.
